# EUROPEAN PATENT SPECIFICATION

(11) **EP 0 481 726 B1**
(45) Date of publication and mention of the grant of the patent: **11.05.1994**
(21) Application number: 91309481.9
(22) Date of filing: 15.10.1991
(51) Int. Cl.: H05K 7/10

(54) **Socket for electric part**
Sockel für ein elektrisches Teil
Douille pour une pièce électrique

(30) Priority: 17.10.1990 JP 278461/90
(43) Date of publication of application: 22.04.1992
(73) Proprietor: YAMAICHI ELECTRONICS CO., LTD., Ohta-ku, Tokyo (JP)
(72) Inventor: Uratsuji, Kazumi, Tokyo (JP)
(74) Representative: Wood, Anthony Charles

(56) References cited:
- EP-A- 0 118 346
- EP-A- 0 295 046
- EP-A- 0 390 543
- US-A- 4 623 208
- US-A- 4 886 470

## Description

### BACKGROUND OF THE INVENTION

### 1. FIELD OF THE INVENTION

This invention relates to a zero insertion type socket for an electric part including a means for displacing a contact between a contacted position and a released position.

### 2. BRIEF DESCRIPTION OF THE PRIOR ART

In a conventional socket represented by US-A-4623208, etc., a contact itself includes a cantilevered arm projecting outwardly. When the cantilevered arm is pushed down with a presser cover, a curved spring portion, which is provided to the contact itself, is flexed in the compressing direction to realize an outward displacement as a component of force, thereby to separate a contact nose portion away from a contact of an IC, so that the IC can be inserted and removed with no load.

In the above-mentioned conventional IC socket, the operational force for pushing down the presser cover and the contacting force of the contact are determined by the spring portion of the contact.

Accordingly, if a spring constant of the spring portion is increased in order to increase the contacting force, the operational force for pushing down the presser cover is also increased. On the contrary, if the spring constant of the spring portion is reduced in order to reduce the operational force, the contacting force is also reduced. The conventional IC socket had such incompatible problems as just mentioned. Therefore, it was difficult for the conventional IC socket to be such designed as to satisfy both the requirements for reducing the operational force as much as possible and increasing the contacting force.

The constitution where the spring portion is compressed in order to obtain an outward displacement motion by pushing down the cantilevered arm has such inconveniences as that the outward displacement amount realized as a component of force relative to the pushing down amount is very limited, and an efficient amount of displacement is unobtainable relative to the pushing down amount.

It has also such inconveniences as that when the cantilevered arm is pushed down, the axis of the contact tends to be twisted, an undesirable shifting is generated to the contact nose portion, and a metal fatigue tends to be accumulated in the basal portion of the cantilevered arm when an external force is repeatedly exerted to the cantilevered arm in the curved direction.

In the conventional contact, various complicated designing requirements or conditions must be satisfied, such as setting of a sectional area for providing a certain strength, setting of the spring constant, counter-measure for twisting, etc.

### SUMMARY OF THE INVENTION

It is therefore an object of the present invention to provide a socket for an electric part capable of reducing the pushing down operational force and increasing the contacting force.

Another object of the present invention is to provide a socket for an electric part capable of causing an efficient outward displacement upon pushing down operation and thus, capable of obtaining a sufficient amount of outward displacement with a limited pushing down amount.

A further object of the present invention is to provide a socket for an electric part capable of solving such problems as twisting of a contact resulting from a pushing down operation and metal fatigue of a cantilevered arm, and of soundly displacing the contact even if the socket is used repeatedly.

To achieve the above objects, there is provided a socket for an electric part including a pivotable lever disposed along a row of contacts each having a contact nose portion and a spring portion, one end of the pivotable lever being solidly connected with the contact and the other end thereof being extended outwardly from the engaging portion, the pivotable lever being supported such as to be pivoted while sliding on an idle fulcrum, the pivotable lever, when the other end thereof is pushed down, being pivoted while sliding on the idle fulcrum to permit the connecting portion to displace a contact nose of the contact outwardly against resiliency of the spring portion, so that the contact nose is separated away from a contact of an electric part thus enabling to insert and remove the electric part with no load.

In the socket for an electric part according to the present invention, when one end of the pivotable lever supported by the idle fulcrum is pivoted downward while sliding on the idle fulcrum, and the one end portion of the pivotable lever exerts an outward force to the contact. As a result, the contact is displaced outwardly against the resiliency of the spring portion and separated away from the contact of the electric part accommodated in the electric part accommodating space to release the electric part. Therefore, the electric part can be removed or inserted with no-load.

When the pushing down force exerted to the other end portion of the pivotable lever is released, the pivotable lever is pivoted upwardly and sliding by resiliency of the spring portion of the contact and then waits for the next pushing down operation. At the same time, the contact is displaced inwardly by being biased by spring portion and brought into contact with the the upper surface of the contact of the electric part under pressure.

In the above-mentioned socket for an electric part, the spring portion of the contact can be arranged to have such a spring constant as being contacted with the contact of the electric part with a proper contacting force. On the other hand, the pivotable lever can be pushed down with a reduced operational force in accordance with the principle of lever. Even if the spring constant of the spring portion of the contact is set large, this is not directly resulted in increase of the pushing down force, and the pushing down force can be reduced by properly setting the distances of the operating portion and acting portion from the pivotal fulcrum of the pivotable lever. At the same time, the object for increasing the contacting force can also be achieved.

Furthermore, since the pivotable lever exerts an outward force directing upward at angles to the contact so that the contact is separated away from the contact of an electric part, the outward displacement of the contact can efficiently be realized relative to the pushing down force of the pivotable lever, and a sufficient space for accommodating the electric part can be released.

Moreover, such unfavorable problems as twisting of the contact and an accumulation of metal fatigue in the cantilevered arm as had in the prior art where the cantilever arm of the contact is pushed down are not arisen, and the contact can be soundly displaced even if the socket is repeatedly used.

The above and other objects and attendant advantages of the present invention will be readily apparent to those skilled in the art from a reading of the following detailed description in conjunction with the accompanying drawings which show preferred embodiments of the present invention.

### BRIEF DESCRIPTION OF THE DRAWINGS

Figs. 1 through 4 show the embodiment of the present invention, wherein:
Fig. 1 is a perspective view showing an outer appearance of a socket for an electric part;
Figs. 2 and 3 are sectional views of an important part of the socket for an electric part, showing open and closed states of a contact caused by a pivotable lever; and
Fig. 4 is a sectional view showing an operating state of an important part of the socket for an electric part, wherein the contact is in contact with a contact of the electric part under pressure.

### DETAILED DESCRIPTION OF THE EMBODIMENT

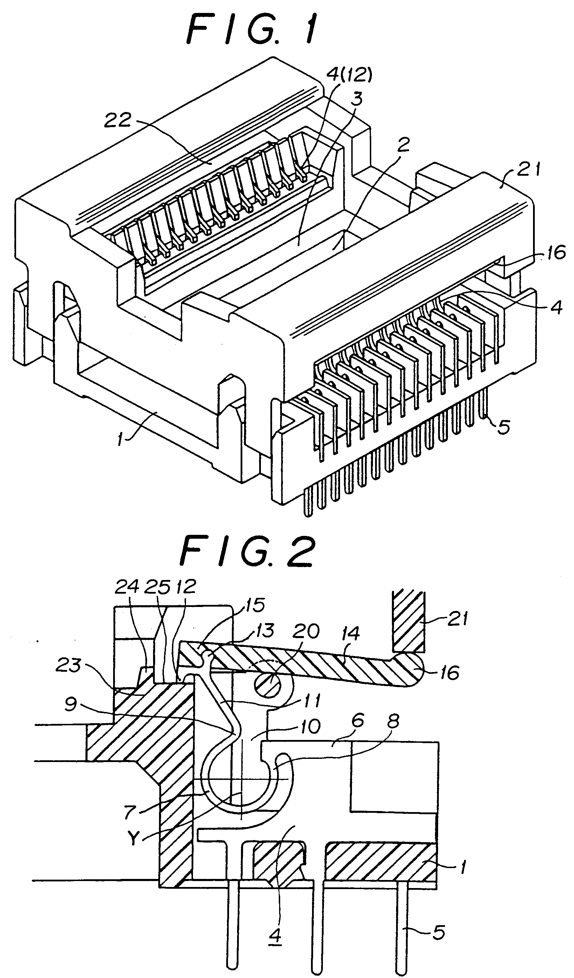

The embodiment of the present invention will be described hereinafter in detail with reference to Figs. 1 through 4 of the accompanying drawings.

A base member 1 formed of an insulated material has a central opening 2 through its upper and lower surfaces. A space 3 for accommodating an electric part is defined on the upper surface side of the central opening 2. The base member 1 is provided with a plurality of contacts arranged in parallel relation along at least two opposed sides of the space 3.

The contacts 4 are implanted in the base member 1. Each contact 4 includes a male terminal 5 extending downward from a lower surface of the base member 1. The contact 4 also includes a flat portion 6 connected next to a basal portion of the male terminal 5. The flat portion 6 is supported on and vertically erected from an upper surface of an implanted wall of the contact. The contact 4 further includes a spring portion 7 connected next to an inner edge of an upper end of the flat portion 6. The spring portion 7 has a curved shape extending downward from its connected portion (basal portion 8) with the flat portion 6 and then curved back to the vicinity of the connected portion. In other words, the spring portion 7 has a downwardly directed curved shape. An angle of the curve is set such that a predetermined small distance 10 is formed between the basal portion 8 and a distal end 9 of the spring portion 7 extending from the basal portion 8. This angle of the curve is preferably set to 180 degrees or more, and more preferably to 250 degrees or more. In other words, the spring portion 7 is curved such that the distal end 9 thereof reaches the vicinity of an upper end of a vertical center line Y of the curved spring portion 7. The contact 4 further includes a contact arm 11 connected next to the distal end 9 of the curved spring portion 9 and inclining inwardly. The contact arm 11 terminates in a contact nose projecting inwardly and and downwardly from its distal end.

The spring portion 7 urges the contact arm 11 and the contact nose 12 inwardly so that the contact nose 12 is brought into contact with a contact 18 of an electric part 17 represented by IC. The contact 4 further includes an engaging element 13 extending upwardly from the distal end of the arm 11, that is, from the connected portion between the arm 11 and the contact nose 12. An acting portion 15 of the pivotable lever 14 is brought into engagement with the engaging element 13. The pivotable lever 14 is extended in parallel relation with a row of the contacts 4 at the outer side of the contacts. The pivotable lever 14 is provided at one end thereof with an acting portion 15 and at the other end thereof with an operating portion 16 extending outward. The acting portion 15 is engaged with the engaging element 13. For example, the engaging element 13 is integrally connected with the acting portion 15 of the pivotable lever 14. The engaging element 13 is integrally connected with the pivotable lever 14 by molding or otherwise the engaging element 13 is press fitted into the pivotable lever 14 for integral connection. The pivotable lever 14 forms a the operating portion 16 extending outwardly from the engaged portion. Accordingly, the pivotable lever 14 itself has a pivotal fulcrum, while forming a part of the contact 4. The fulcrum of the pivotable lever 14 is an idle fulcrum which moves tracing a certain orbit.

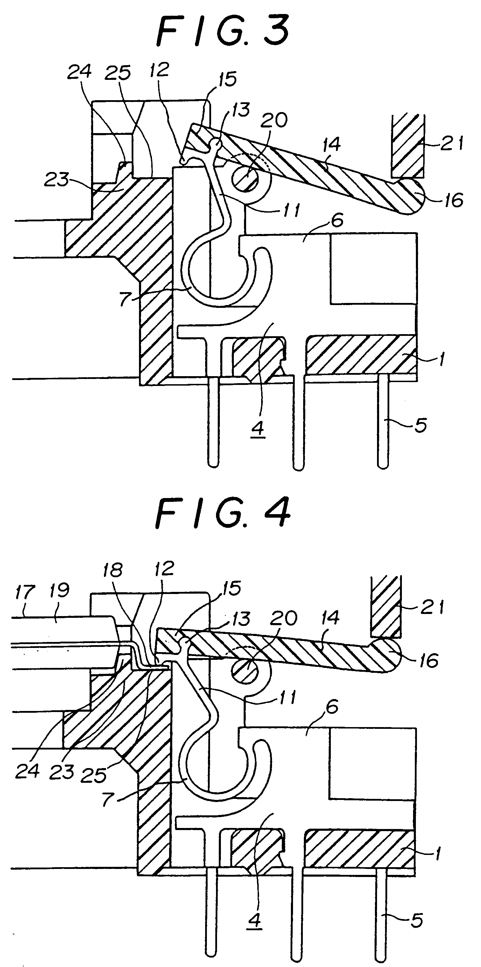

The drawings show one example of the structure of the idle fulcrum. As illustrated, the pivotable lever 14 is placed on a guide shaft 20 disposed on the base member 1 side at a mid-way of the pivotable lever 14, i.e., somewhere between the acting portion 15 and the operating portion 16 and supported thereon such that the pivotable lever 14 is pivoted upwardly and downwardly while sliding on the surface of the guide shaft 20. When the lever 14 is pivoted, the pivotal fulcrum moves about the guide shaft 20. That is, when the operating portion 16 is pushed down from the state shown in Fig. 2, the pivotable lever 14 is pivoted downwardly while sliding on the surface of the guide shaft 20 from its upper dead point toward its lower dead point, and the acting portion 15 exerts an outward force to a free end of the contact 4 through the engaged portion to realize an outward displacement against the resiliency of the spring portion 7 as shown in Fig. 3. As a result, the contact nose portion 12 is moved to a non-contacting position to form an non-interference state with the electric part 17. In that state, the electric part 17 can freely be inserted and removed.

Also, the pivotable lever 14 is pivoted upwardly while sliding on the surface of the guide shaft 20 by the resiliency of the spring portion 7. At the same time, as shown in Fig. 4, the contact 4 is displaced inwardly by the resiliency of the spring portion 7 to urge the contact nose portion 12 against the upper surface of the contact 18 of the electric part.

Although not illustrated, a pivotal movement about an idle fulcrum can be realized by bringing the fulcrum of the pivotable lever 14 into slide engagement with a face cam or a groove cam. Although not illustrated, a plurality of pivotable levers 14 can be provided per row of the contacts 4. In other words, one group of contacts arranged in a row can be divided into small groups of contacts, and the small groups of contacts can be displaced by separate pivotable levers. The pivotable lever 14 can directly be pushed down by robot or by manual operation at the operating portion 16. As shown in Fig. 1, the cover 21 is disposed over the base member 1, and a central window 22 formed in the cover 21 is faced with the electric part accommodating space 3 of the base member 1, so that the electric part 17 can be inserted into and removed from the space 3 through the central window 22. The lower surface of the presser cover 21 is placed on the operating portion 16 of the pivotable lever 14, and the operating portion 16 is pushed down by depressing the presser cover 21 by robot or by manual operation.

A wall 23 defining the electric part accommodating space 3 is provided with a positioning ridge 24 projecting upwardly therefrom, so that the side of the electric part's body 19 is supported by the positioning ridge 24. Further, the lower surface of the contact 18 is supported by a contact supporting surface 25 formed on the upper surface of the wall 23 at the outer side of the positioning ridge 24, and the contact nose 12 is brought into contact with the upper surface of such supported contact 18 under a downward pressure.

As shown in fig. 3, when the electric part 17 is already removed, the contact nose 12 is in contact with the contact supporting surface 25 so that the contact 4 is not displaced inwardly by a predetermined amount or more. In other words, the contact supporting surface 25 forms a stopper for limiting the inwardly displacing amount of the contact 4. As a result, the operating portion 16 of the pivotable lever 14 is normally upwardly pivoted to a fixed position by the elasticity of the contact 4 and held in a waiting state.

As described above, when the pivotable lever 14 is pushed down at the operating portion 16, the pivotable lever 14 is pivoted downwardly while moving the fulcrum on the surface of the guide shaft 20. That is, the pivotable lever 14 is pivoted about the idle fulcrum. By this, an outward displacement of the contact 4 is effectively made by the acting portion 15. More specifically, at an initial stage of the downward pivotal movement about the idle fulcrum, the pivotable lever 14 is continuously pivoted about the idle fulcrum to displace the contact nose portion 12 backwardly while effectively generating a force for pulling up the contact nose portion 7 of the contact 4. In other words, the pivotable lever 14 can efficiently separate the contact nose portion 12 of the contact 4 upwardly at angles away from the contact 18 of the electric part.

According to the present invention, the spring portion of the contact can be set to have such a spring constant as being able to contact with the contact of the electric part with a proper contacting force. Accordingly, the contact can be freely designed without being restricted by the operating force of the pivotable lever. On the other hand, the pivotable lever can be pushed down with a reduced force in accordance with the principle of lever. Even if the spring constant of the spring portion of the contact is increased, this does not directly lead to the increase of the pushing down force. By properly setting the distances of the operating portion and acting portion from the guide shaft supporting the pivotable lever, the operating force can be reduced. As a result, the object for increasing the contacting force can also be achieved while realizing a reduced operating force.

Furthermore, since the acting portion of the contact displaces the contact outwardly to separate the contact nose portion from the contact of the electric part while pulling up the contact nose portion at the initial stage of the pivotal movement, the contact can efficiently be displaced outwardly upon pushing-down operation of the pivotable lever. As a result, the electric part accommodating space can be sufficiently released. Especially, when the pivotable lever is pivoted downward about the idle fulcrum while sliding on the surface of the guide shaft, it can efficiently pull up the contact nose portion of the contact.

Moreover, there can effectively be prevented a twist as had in the prior art where the cantilevered arm of a contact is depressed and an accumulation of metal fatigue in the cantilevered arm. As a result, the contact can be displaced without any problem even if it is used repeatedly.

## Claims

1. A socket for an electric part (17) including an electric part accommodating space (3), and a plurality of contacts (4) arranged in parallel relation along at least two opposing sides of said space (3), said contacts each including a contact nose portion (12) to be contacted with a contact (18) of said electric part (17) accommodated in said electric part accommodating space (3), and a spring portion (7) for biasing said contact nose portion (12) inwardly in order to obtain a contacting pressure with said contact (18) of said electric part (17), characterize in that said socket for an electric part (17) further includes a pivotable lever (14) disposed along a row of contacts (4), one end (15) of said pivotable lever being solidly connected with said contact (4, 13) and the other end (16) thereof being extended outwardly of said contact (4) from said connecting portion (13), said pivotable lever (14) being supported such as to be pivoted while sliding on an idle fulcrum, said pivotable lever (14), when the other end (16) thereof is pushed down, being pivoted while sliding on said idle fulcrum to permit said connecting portion (13) to displace said contact nose (12) of said contact outwardly against the resiliency of said spring portion (7), so that said contact nose (12) is separated away from said contact (18) of said electric part (17).

2. A socket for an electric part (17) as claimed in claim 1, wherein said pivotable lever (14) is placed on a guide shaft (20), and idly pivoted about the peripheral surface of said guide shaft (20).

## Patentansprüche

1. Sockel für ein elektrisches Teil (17) mit einer Aufnahme (3) für das Teil (17) und einer Mehrzahl von an mindestens zwei einander gegenüberliegenden Seiten der Aufnahme (3) in Abständen parallel zueinander verlaufend angeordneten Kontakten (4) mit jeweils einer mit einem Anschlußkontakt (18) des in die Aufnahme (3) eingefügten elektrischen Teil (17) Kontakt eingehenden Kontaktnase (12) und einem die Nase (12) unter Erzeugung eines hinreichenden Anpreßdrucks in Kontakt mit dem Anschlußkontakt (18) des elektrischen Teils (17) überführenden Federbereich (7), dadurch gekennzeichnet, daß dem Sockel entlang einer Reihe von Kontakten (4) ein verschwenkbarer Hebel (14) zugeordnet ist, dessen eines Ende (15) mit den Kontakten (4) verbunden ist (13) und dessen anderes Ende sich von dem mit den Kontakten (4) zusammengefaßten (13) Ende (15) nach außen weg erstreckt, wobei der Hebel (14) auf einer Hebelstütze verschwenkbar auf dieser Stütze quer dazu verlagerbar gelagert ist, so daß der Hebel (14) beim Absenken seines freien Endes (16) auf der Hebelstütze verschwenkend und sich quer dazu verlagernd die Kontaktnase (12) der Kontakte (4) von dem jeweiligen Anschlußkontakt (18) des elektrischen Teils (17) gegen die Rückstellkraft des Federbereichs (7) der Kontakte (4) abhebt.

2. Sockel für ein elektrisches Teil (17) nach Anspruch 1, dadurch gekennzeichnet, daß der Hebel (14) von einer Achse (20) sich am Unfang der Achse (20) frei abstützend unterfangen ist.

## Revendications

1. Socle pour une pièce électrique (17), comportant un espace de réception (3) d'une pièce électrique, et une pluralité de contacts (4) disposés parallèlement les uns aux autres le long d'au moins deux côtés opposés de l'espace (3), ces contacts comportant chacun une partie de nez de contact (12) destinée à venir en contact avec un contact (18) de la pièce électrique (17) disposée dans l'espace (3) de réception de pièce électrique et une partie élastique (7) pour pousser la partie de nez de contact (12) vers l'intérieur dans le but d'obtenir une pression de contact contre le contact (18) de la pièce électrique (17), caractérisé en ce que le socle pour une pièce électrique (17) comporte en outre un levier pivotant (14) disposé le long d'une rangée de contacts (4), une extrémité (15) du levier pivotant étant solidement connectée au contact (4, 13) et son autre extrémité (16) s'étendant vers l'extérieur à partir du contact (4) de la partie de connexion (13), le levier pivotant (14) étant supporté de manière à pouvoir pivoter tout en glissant sur un pivot libre, le levier pivotant (14), lorsque son autre extrémité (16) est poussée vers le bas, étant entraîné en rotation tout en glissant sur l'axe libre pour permettre à la partie de connexion (13) de déplacer le nez de contact (12) du contact tourné vers l'extérieur, à l'encontre de l'élasticité de la partie élastique (7), de façon que le nez de contact (12) soit écarté du contact (18) de la pièce électrique (17).

2. Socle pour une pièce électrique (17) selon la revendication 1, caractérisé en ce que le levier pivotant (14) est placé sur un arbre de guidage (20), et pivote librement autour de la surface périphérique de l'arbre de guidage (20).
